# EUROPÄISCHE PATENTSCHRIFT

(11) **EP 3 098 610 B1**
(45) Veröffentlichungstag und Bekanntmachung des Hinweises auf die Patenterteilung: **10.04.2019**
(21) Anmeldenummer: 15169887.5
(22) Anmeldetag: 29.05.2015
(51) Int. Cl.: G01R 19/25, H02H 1/00, H02H 3/28

(54) **LEISTUNGSMESSGERÄT UND MESSSYSTEM ZUR MESSUNG DER LEISTUNG MEHRERER PHASEN IN EINEM MEHRPHASENSYSTEM**
POWER MEASURING DEVICE AND MEASURING SYSTEM FOR MEASURING THE POWER OF MULTIPLE PHASES IN A MULTI-PHASE SYSTEM
APPAREIL DE MESURE DE PUISSANCE ET SYSTÈME DE MESURE DESTINÉ À MESURER LA PUISSANCE DE PLUSIEURS PHASES DANS UN SYSTÈME MULTIPHASES

(43) Veröffentlichungstag der Anmeldung: 30.11.2016
(73) Patentinhaber: HAMEG Instruments GmbH, 63533 Mainhausen (DE)
(72) Erfinder: Schütz, Andreas, 63791 Karlstein (DE); Geier, Eugen, 63512 Hainburg (DE); Asmussen, Holger, 45472 Mülheim (DE); Vogel, Josef, 68723 Plankstadt (DE)
(74) Vertreter: Körfer, Thomas

(56) Entgegenhaltungen:
- EP-A2- 2 784 449
- US-A1- 2009 292 486
- US-A1- 2012 278 016
- US-A1- 2013 211 754
- US-A1- 2015 028 851

## Beschreibung

Die Erfindung betrifft ein Leistungsmessgerät und ein Messsystem, welche zur flexiblen Messung der Leistung auf einer oder mehreren Phasen eines Mehrphasensystems, insbesondere eines Drehstromsystems, dienen. Leistungsmessgeräte sind herkömmlicherweise entweder zur Messung der Leistung auf einer Phase eines Drehstromsystems oder zur Messung der Leistung auf drei Phasen eines Drehstromsystems ausgelegt. Einfache Leistungsmessgeräte, welche lediglich ausgelegt sind, um die Leistung auf einer Phase eines Drehstromsystems zu messen, sind kostengünstig und verfügen lediglich über einen geringen Platzbedarf in einem Messaufbau. Herkömmliche Messgeräte, welche ausgelegt sind, um die Leistung auf drei Phasen eines Drehstromsystems zu messen, sind deutlich kostenintensiver und verfügen üblicherweise über einen deutlich vergrößerten Platzbedarf in einem Messaufbau.

So zeigt beispielsweise das Dokument DE 10 2012 107 021 B4 ein Leistungsmessgerät, welches ausgebildet ist, um die Leistung auf drei Phasen eines Drehstromsystems zu messen. Weitere relevante Dokumente aus dem Stand der Technik sind US 2013/211754 A1, EP 2 784 449 A2, US 2015/028851 A1 sowie US 2009/292486 A1.

Einphasige Leistungsmessgeräte weisen darüber hinaus den Nachteil auf, dass keine relativen Messungen zwischen verschiedenen Phasen des Drehstromsystems möglich sind. Auch durch Anschaffung einer Mehrzahl derartiger einphasiger Messgeräte kann dies nicht erreicht werden, da keine Synchronisierungsmöglichkeit der Messgeräte besteht.

Der Erfindung liegt die Aufgabe zugrunde, ein Messsystem zu schaffen, welches eine genaue Vermessung von Mehrphasensystemen mit mehreren Phasen, insbesondere von Drehstromsystemen, ermöglicht, gleichzeitig jedoch nur eine geringe Einstandsinvestition erfordert.

Die Aufgabe wird erfindungsgemäß durch die Merkmale des unabhängigen Anspruchs 1 gelöst. Vorteilhafte Weiterbildungen sind Gegenstand der hierauf rückbezogenen Unteransprüche.

Ein erfindungsgemäßes Messsystem umfasst zumindest zwei Leistungsmessgeräte. Ein derartiges Leistungsmessgerät dient der Messung der Leistung eines Mehrphasensystems, insbesondere eines Drehstromsystems. Es verfügt über eine Messeinrichtung zur Messung einer Leistung einer ersten Phase des Mehrphasensystems, eine Anzeigeeinrichtung zur Darstellung von Messergebnissen und eine Bedieneinrichtung zur Bedienung des Leistungsmessgeräts durch einen Benutzer. Darüber hinaus weist es eine Kommunikationseinrichtung auf, mittels welcher es mit einem oder mehreren weiteren Leistungsmessgeräten kommunizieren kann. Das erfindungsgemäße Leistungsmessgerät ist dabei ausgebildet, um gemeinsam mit dem einen oder mehreren weiteren Leistungsmessgeräten eine Leistung mehrerer Phasen des Mehrphasensystems zu messen. Somit ist es möglich, ein einzelnes erfindungsgemäßes Leistungsmessgerät einzusetzen, um lediglich eine Leistungsmessung an einer Phase durchzuführen. Mehrere erfindungsgemäße Leistungsmessgeräte können gemeinsam genutzt werden, um phasensynchrone Messungen an mehreren Phasen des Mehrphasensystems durchzuführen.

Vorzugsweise kann das Leistungsmessgerät in einem Master-Modus betrieben werden, in welchem das Leistungsmessgerät das zumindest eine weitere Leistungsmessgerät steuert. Zusätzlich kann das Leistungsmessgerät in einem Slave-Modus betrieben werden, in welchem das Leistungsgerät von zumindest einem weiteren Leistungsmessgerät gesteuert wird. So wird erreicht, dass mehrere baugleiche erfindungsgemäße Leistungsmessgeräte zur gemeinsamen Vermessung der verschiedenen Phasen eingesetzt werden können.

Vorzugsweise ist das Leistungsmessgerät ausgebildet, um im Master-Modus Messergebnisse von dem zumindest einem weiteren Leistungsmessgerät mittels der Kommunikationseinrichtung zu empfangen, und/oder Messergebnisse des Leistungsmessgeräts und des zumindest einen weiteren Leistungsmessgerät auf der Anzeigeeinrichtung darzustellen, und/oder Bedieneingaben für das Leistungsmessgerät und das zumindest eine weitere Leistungsmessgerät mittels der Bedieneinrichtung entgegenzunehmen und zu verarbeiten. Weiterhin ist das Messgerät vorzugsweise ausgebildet, um im Slave-Modus Messergebnisse an das zumindest eine weitere Leistungsmessgerät mittels der Kommunikationseinrichtung zu übertragen, und/oder keine Messergebnisse auf der Anzeigeeinrichtung des Leistungsmessgeräts darzustellen, und/oder keine Bedieneingaben mittels der Bedieneinrichtung des Leistungsmessgeräts entgegenzunehmen und zu verarbeiten. So wird erreicht, dass sämtliche verbundene erfindungsgemäße Leistungsmessgeräte über die Anzeigeeinrichtung und Bedieneinrichtung eines einzelnen unter den Leistungsmessgeräten gesteuert werden. Eine besonders einfache Bedienung ist somit möglich.

Vorzugsweise ist die Messeinrichtung dabei ausgebildet, um einen Strom und eine Spannung auf der ersten Phase des Mehrphasensystems, insbesondere Drehstromsystems, zu messen und die Leistung der ersten Phase aus dem Strom und der Spannung auf der ersten Phase zu berechnen. So kann eine besonders einfache und genaue Leistungsmessung erfolgen.

Vorzugsweise ist die Kommunikationseinrichtung ausgebildet, um an einen seriellen oder parallelen oder ringförmigen Kommunikationsbus angeschlossen zu werden und mittels des Kommunikationsbusses mit dem zumindest einen weiteren Leistungsmessgerät zu kommunizieren. So ist eine sehr einfache Kommunikation zwischen den Leistungsmessgeräten möglich.

Vorzugsweise verfügt die Kommunikationseinrichtung über einen bidirektionalen digitalen Koaxial-Anschluss. Sie ist in diesem Fall ausgebildet, um mittels dieses Anschlusses mit dem zumindest einen weiteren Leistungsmessgerät verbunden zu werden. Alternativ verfügt die Kommunikationseinrichtung über einen unidirektionalen digitalen Koaxial-Eingangs-Anschluss und einen unidirektionalen digitalen Koaxial-Ausgangs-Anschluss. In diesem Fall ist die Kommunikationseinrichtung ausgebildet, um mittels des unidirektionalen digitalen Koaxial-Eingangs-Anschlusses und des unidirektionalen digitalen Koaxial-Ausgangs-Anschlusses mit dem zumindest einen weiteren Leistungsmessgerät verbunden zu werden. Über diese Anschlüsse ist auch eine ringförmige Verbindung einer größeren Anzahl von Leistungsmessgeräten möglich. So ist eine große Flexibilität beim Aufbau der Leistungsmessgeräte und eines daraus zusammengesetzten Messsystems möglich.

Vorzugsweise verfügt die Kommunikationseinrichtung über eine Anschlussschnittstelle, welche ausgebildet ist, um eine automatische Verbindung zu dem zumindest einen weiteren Leistungsmessgerät herzustellen. Die automatische Verbindung kann dabei entweder direkt durch kabelloses Zusammenstecken der Leistungsmessgeräte mittels der jeweiligen Anschluss-Schnittstelle erfolgen. Alternativ kann die automatische Verbindung mittels einer Anschlussvorrichtung hergestellt werden, an welche das Leistungsmessgerät und das zumindest eine weitere Leistungsmessgerät gesteckt werden. So ist eine besonders einfache kabellose Verbindung der Leistungsmessgeräte möglich. Darüber hinaus wird eine besonders genaue Synchronisierung ermöglicht, da keine Ungenauigkeiten aufgrund unterschiedlicher Kabel-Längen oder Verlegungen entstehen können.

Vorzugsweise ist die Kommunikationseinrichtung ausgebildet, um eine Synchronisierung des Leistungsmessgeräts und des zumindest einen weiteren Leistungsmessgeräts zur phasenkohärenten Messung durchzuführen. Zusätzlich oder alternativ ist die Kommunikationseinrichtung ausgebildet, um Messergebnisse zu übertragen und/oder um Steuerbefehle zu übertragen. So können sämtliche zwischen den Leistungsmessgeräten auszutauschenden Informationen und Befehle über die Kommunikationseinrichtung ausgetauscht werden. Ein besonders einfacher Aufbau des Leistungsmessgeräts ist dadurch möglich.

Bevorzugt ist die Kommunikationseinrichtung weiterhin ausgebildet, um zur Synchronisierung des Leistungsmessgeräts und des zumindest einen weiteren Leistungsmessgeräts eine Synchronisierungsnachricht an das zumindest eine weitere Leistungsmessgerät zu senden, eine Zeitdauer bis zum Eintreffen einer Antwort des zumindest einen weiteren Leistungsmessgeräts abzuwarten und zu bestimmen und die Hälfte der Zeitdauer bis zum Eintreffen der Antwort des zumindest einen weiteren Leistungsmessgeräts als Übertragungszeit der Synchronisierungsnachricht zu schätzen. Die Messeinrichtung ist in diesem Fall dazu ausgebildet, um bei einer Verarbeitung der Messergebnisse des zumindest einen weiteren Leistungsmessgeräts die geschätzte Übertragungszeit der Synchronisierungsnachricht als Verzögerung einer Übertragung von Steuerbefehlen und Messergebnissen zu berücksichtigen. Eine besonders genaue Synchronisierung ist somit möglich. Damit können besonders genaue Messergebnisse erzielt werden.

Die Kommunikationseinrichtung ist vorzugsweise weiterhin ausgebildet, um mit zumindest zwei, insbesondere zwei, oder drei, oder vier, oder fünf, oder sechs, oder sieben, oder acht, oder neun, oder zehn weiteren Leistungsmessgeräten zu kommunizieren. Das Leistungsmessgerät ist dann weiterhin ausgebildet, um gemeinsam mit den weiteren Leistungsmessgeräten eine Leistung auf weiteren Phasen des Mehrphasensystems, insbesondere Drehstromsystems, zu messen. Eine besonders große Messflexibilität wird damit erreicht.

Ein erfindungsgemäßes Messsystem verfügt über ein erstes und ein zweites zuvor beschriebenes Leistungsmessgerät. Die Kommunikationseinrichtung des ersten Leistungsmessgeräts und die Kommunikationseinrichtung des zumindest einen zweiten Leistungsmessgeräts sind dabei miteinander verbunden. Die Kommunikationseinrichtungen sind ausgebildet, um miteinander zu kommunizieren. Das erste Leistungsmessgerät und das zumindest eine zweite Leistungsmessgerät sind dabei ausgebildet, um gemeinsam eine Leistung auf zumindest zwei Phasen des Mehrphasensystems, insbesondere Drehstromsystems, zu messen. So kann eine genaue Messung bei geringer Einstandsinvestition erreicht werden.

Vorzugsweise sind die Leistungsmessgeräte wie zuvor beschrieben in einem Master-Modus und einem Slave-Modus betreibbar. Beispielsweise wird das erste Leistungsmessgerät im Master-Modus betrieben und das zweite Leistungsmessgerät im Slave-Modus betrieben. So sind die Aufgaben in dem Messsystem klar verteilt. Eine besonders einfache Bedienung und ein besonders einfaches Ablesen von Messergebnissen werden so erreicht.

Vorzugsweise verfügt das Messsystem über zumindest ein, bevorzugt zwei, weitere(s) (zweite) Leistungsmessgerät(e). Jedes der zweiten Leistungsmessgeräte ist ausgebildet, um eine Leistung auf einer unterschiedlichen Phase des Drehstromsystems zu messen. Das erste Leistungsmessgerät und die zweiten Leistungsmessgeräte sind ausgebildet, um gemeinsam die Leistung auf einer Mehrzahl an Phasen, bevorzugt sämtlichen Phasen des Mehrphasensystems, insbesondere Drehstromsystems, zu messen. So kann eine sehr genaue Messung der Gesamtleitung erfolgen. Die Hinzunahme von weiteren zweiten Leistungsmessgeräten in das Messsystem ermöglicht eine Vielzahl weiterer Messungen in zum Beispiel Primär- und Sekundärstromkreisen gekoppelter Systeme.

Vorzugsweise sind die Leistungsmessgeräte des Messsystems ausgebildet, um das zuvor beschriebene Synchronisierungsverfahren durchführen zu können. Das erste Leistungsmessgerät ist dabei ausgebildet, um die Synchronisierungsnachricht an das zumindest eine zweite Leistungsmessgerät zu senden. Das zumindest eine zweite Leistungsmessgerät ist dann ausgebildet, um einen Antwort auf die Synchronisierungsnachricht an das erste Leistungsmessgerät zu übertragen, sobald es die Synchronisierungsnachricht empfangen hat. So kann eine besonders genaue Synchronisierung erfolgen.

Vorzugsweise verfügt das Messsystem über Messleitungen identischer Länge zum Anschluss des ersten Leistungsmessgeräts und des zumindest einen zweiten Leistungsmessgeräts an die Phasen des Mehrphasensystems. Durch die identischen Leitungslängen werden identische Signalverzögerungen erreicht. Eine Synchronisierung kann dadurch vereinfacht werden. Auch eine genauere Synchronisierung kann dadurch erreicht werden.

Vorzugsweise verfügen die Leistungsmessgeräte des Messsystems über die zuvor beschriebene Anschluss-Schnittstelle. Das Messsystem verfügt dann über eine Anschlussvorrichtung zur automatischen Verbindung der Leistungsmessgeräte bei einem Aneinanderstecken des jeweiligen Leistungsmessgeräts und der Anschlussvorrichtung. Ein besonders einfaches Verbinden der Leistungsmessgeräte wird so erreicht.

Nachfolgend wird die Erfindung anhand der Zeichnung, in der ein vorteilhaftes Ausführungsbeispiel der Erfindung dargestellt ist, beispielhaft beschrieben. In der Zeichnung zeigen:
- Fig. 1: ein Blockschaltbild eines Ausführungsbeispiels des erfindungsgemäßen Leistungsmessgeräts in einem Blockschaltbild;
- Fig. 2: ein Blockschaltbild eines ersten Ausführungsbeispiels des erfindungsgemäßen Messsystems;
- Fig. 3: ein Blockschaltbild eines zweiten Ausführungsbeispiels des erfindungsgemäßen Messsystems, und
- Fig. 4: ein Blockschaltbild eines dritten Ausführungsbeispiels des erfindungsgemäßen Messsystems.

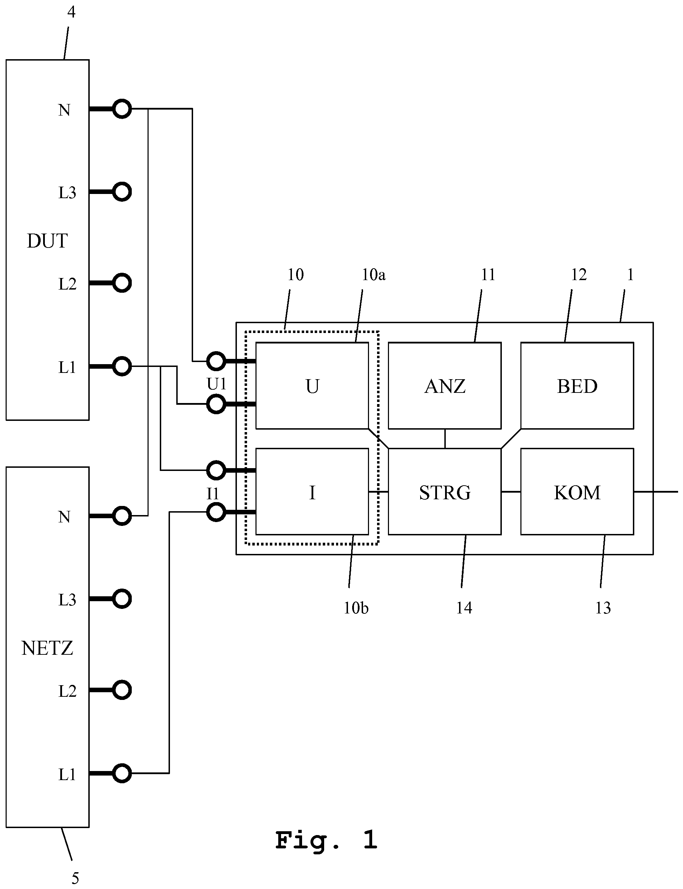

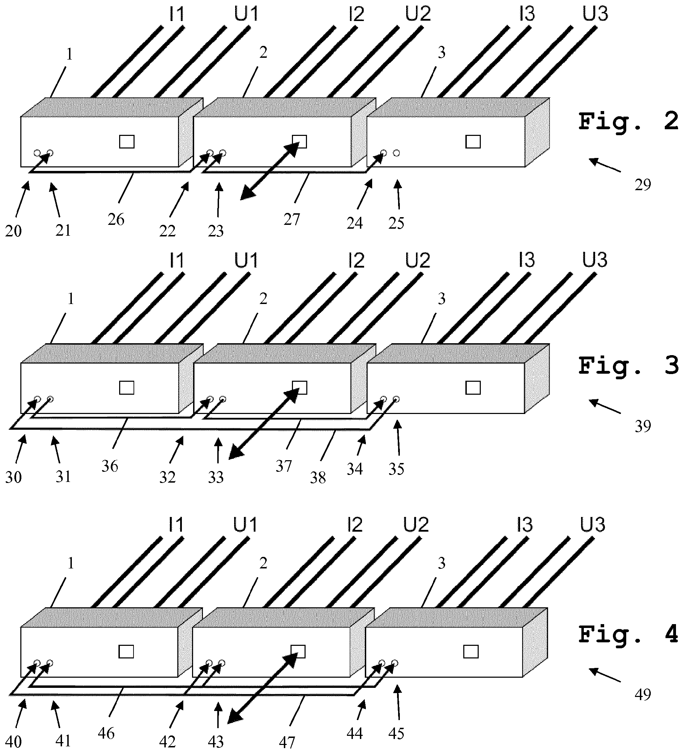

Zunächst wird anhand der Fig. 1 der Aufbau und die generelle Funktionsweise eines Ausführungsbeispiels des erfindungsgemäßen Leistungsmessgeräts am Beispiel einer Drehstrommessung dargestellt. Anhand von Fig. 2 - Fig. 4 wird anschließend auf unterschiedliche Verbindungsmöglichkeiten der Leistungsmessgeräte des Messsystems gemäß der Erfindung eingegangen. Identische Elemente wurden in ähnlichen Abbildungen zum Teil nicht wiederholt dargestellt und beschrieben.

In Fig. 1 ist ein Ausführungsbeispiel des erfindungsgemäßen Leistungsmessgeräts 1 gezeigt. Das Leistungsmessgerät 1 ist mit einem Netzanschluss 5 und einem Messobjekt 4 verbunden. Das Messobjekt 4 ist ebenfalls mit dem Netzanschluss 5 verbunden. Der Übersichtlichkeit halber sind hier lediglich die für die Messung mit dem Leistungsmessgerät 1 relevanten Verbindungen der Phase L1 und des Nullleiters N dargestellt. Tatsächlich sind auch die Phasen L2 und L3 des Netzanschlusses 5 und des Messobjekts 4 jeweils miteinander verbunden.

Das Leistungsmessgerät 1 beinhaltet eine Messeinrichtung 10, eine Anzeigeeinrichtung 11, eine Bedieneinrichtung 12, eine Kommunikationseinrichtung 13 und eine Steuereinrichtung 14. Die Steuereinrichtung 14 ist dabei mit sämtlichen weiteren Einrichtungen 10 - 13 verbunden und steuert diese. Die Messeinrichtung 10 beinhaltet eine Spannungsmesseinrichtung 10a und eine Strommesseinrichtung 10b. Jede dieser Einrichtungen 10a, 10b ist individuell mit der Steuereinrichtung 14 verbunden.

Die Messeinrichtung 10 ist weiterhin mit einer Phase des Drehstromsystems verbunden. Dabei ist die Spannungsmesseinrichtung 10a vor und nach Durchfließen eines Messstroms mit dem zu vermessenden Gerät verbunden. D.h. die Spannungsmesseinrichtung 10a ist mit den Anschlüssen L1 und N des Messobjekts 4 verbunden. Die Strommesseinrichtung 10b dagegen ist in Serie mit dem zu vermessenden Gerät verbunden. D.h. sie mit den Anschlüssen L1 des Netzanschlusses 5 und L1 des Messobjekts 4 verbunden.

Soll eine Messung an nur einer Phase durchgeführt werden, wird das Messgerät 1, insbesondere die Messeinrichtung 10 wie zuvor beschrieben mit dem Drehstromsystem verbunden. Mittels der Bedieneinrichtung 12 kann ein Benutzer die Messung starten. Gesteuert durch die Steuereinrichtung 14 führt die Messeinrichtung 10 die Messung durch. Eine Vielzahl von Messpunkten getrennt nach Strom und Spannung werden aufgezeichnet und an die Steuereinrichtung 14 übertragen. Die Steuereinrichtung 14 kann hieraus durch Multiplikation die Leistung ermitteln. Alternativ kann die Leistungsermittlung auch bereits innerhalb der Messeinrichtung 10 erfolgen. Messergebnisse werden dabei auf der Anzeigeeinrichtung 11 dargestellt. Auch eine Bedienführung kann mittels der Anzeigeeinrichtung 11 erfolgen.

Sollen nun jedoch Messungen an mehreren Phasen des Drehstromsystems gleichzeitig durchgeführt werden, so können zwei oder mehrere Messgeräte gemäß der Erfindung mittels der Kommunikationseinrichtung 13 miteinander verbunden werden. Jedes der Messgeräte wird dann mittels seiner jeweiligen Messeinrichtung 10 mit einer Phase des Drehstromsystems entsprechend dem ersten Messgerät 1 verbunden. Jedes der Messgeräte führt unabhängig voneinander seine Messung an der jeweiligen Phase durch. Die Messergebnisse der einzelnen Messgeräte können anschließend an einen zentralen Steuerrechner übertragen werden.

Alternativ kann eines der Messgeräte die Rolle des Steuerrechners übernehmen. In diesem Fall arbeitet dieses Messgerät in einem Master-Modus und steuert die übrigen Messgeräte. Darüber hinaus nimmt es Messergebnisse von den übrigen Messgeräten entgegen. Auch eine Weiterverarbeitung und Anzeige der Messergebnisse sämtlicher Messgeräte erfolgt dann in dem Master-Leistungsmessgerät. Auch die Bedienung sämtlicher Messgeräte kann über das Master-Leistungsmessgerät erfolgen. In diesem Fall arbeiten alle weiteren Leistungsmessgeräte in einem Slave-Modus und übertragen sämtliche Messergebnisse an das Master-Leistungsmessgerät. Wenn ein Messgerät im Slave-Modus arbeitet, ruht seine Bedieneinrichtung und seine Anzeigeeinrichtung. Die Bedienung und auch die Anzeige von Messergenissen erfolgt lediglich über die Bedieneinrichtung und die Anzeigeeinrichtung des Master-Leistungsmessgeräts.

Auf die detaillierten Verbindungsmöglichkeiten der Messgeräte wird anhand von Fig. 2 bis Fig. 4 näher eingegangen.

In Fig. 2 ist ein erstes Ausführungsbeispiel des erfindungsgemäßen Messsystems 29 gezeigt. Das Messsystem 29 beinhaltet ein erstes Leistungsmessgerät 1, ein zweites Leistungsmessgerät 2 und ein drittes Leistungsmessgerät 3. Das erste Leistungsmessgerät 1 verfügt über einen ersten bidirektionalen Koaxial-Anschluss 20 und einen zweiten bidirektionalen Koaxial-Anschluss 21. Das erste Messgerät 1 ist in diesem Beispiel mit einer ersten Phase eines dreiphasigen Drehstromsystems verbunden, d. h. ein Strom I1 und eine Spannung U1 werden von dem ersten Leistungsmessgerät 1 gemessen und in eine Leistung umgerechnet.

Das zweite Leistungsmessgerät 2 verfügt über einen ersten bidirektionalen Koaxial-Anschluss 22 und einen zweiten bidirektionalen Koaxial-Anschluss 23. In diesem Beispiel ist es mit einer zweiten Phase des dreiphasigen Drehstromsystems verbunden, d. h. es wird ein Strom 12 und eine Spannung U2 von dem zweiten Leistungsmessgerät 2 gemessen und in eine entsprechende Leistung umgerechnet.

Das dritte Leistungsmessgerät 3 verfügt über einen ersten bidirektionalen Koaxial-Anschluss 24 und einen zweiten bidirektionalen Koaxial-Anschluss 25. In diesem Beispiel ist es mit einer dritten Phase des dreiphasigen Drehstromsystems verbunden, d. h. es wird ein Strom I3 und eine Spannung U3 von dem dritten Leistungsmessgerät 3 gemessen und in eine entsprechende Leistung umgerechnet.

Der zweite bidirektionale Koaxial-Anschluss 21 des ersten Messgeräts 1 ist mittels einer Koaxial-Leitung 26 mit dem ersten bidirektionalen Koaxial-Anschluss 22 des zweiten Messgeräts 2 verbunden. Der zweite bidirektionale Koaxial-Anschluss 23 des zweiten Messgeräts 2 ist mittels einer Koaxial-Leitung 27 mit dem ersten bidirektionalen Koaxial-Anschluss 24 des dritten Messgeräts 3 verbunden. Über die Koaxial-Leitungen 26 und 27 sind die drei Messgeräte 1-3 miteinander verbunden. Sie können so miteinander kommunizieren. Ist beispielsweise das zweite Messgerät 2 in einem Master-Modus konfiguriert und das erste Messgerät 1 und das dritte Messgerät 3 jeweils in einem Slave-Modus konfiguriert, so steuert das zweite Messgerät 2 das erste Messgerät 1 und das dritte Messgerät 3 über die Koaxial-Leitungen 26 und 27. Gleichzeitig werden Messergebnisse von den Messgeräten 1, 3 von den Slave-Messgeräten 1, 3 an das Master-Messgerät 2 übertragen.

Die Nutzung von bidirektionalen Verbindungen an jeweils einem einzelnen Anschluss ist jedoch nachteilig, da eine interne Umschaltung zwischen einem Sendebetrieb und einem Empfangsbetrieb an jedem einzelnen Koaxial-Anschluss 20 - 25 notwendig ist. Dies erfordert eine gewisse Zeit und limitiert damit die Kommunikationsgeschwindigkeit.

In Fig. 3 wird ein zweites Ausführungsbeispiel des erfindungsgemäßen Messsystems 39 gezeigt. Hier verfügen die Messgeräte 1 - 3 jeweils über zwei unidirektionale Koaxial-Anschlüsse 30 - 35.

Das erste Messgerät 1 verfügt über einen unidirektionalen Koaxial-Eingangs-Anschluss 30 und einen unidirektionalen Koaxial-Ausgangs-Anschluss 31. Das zweite Messgerät 2 verfügt über einen unidirektionalen Koaxial-Eingangs-Anschluss 32 und einen unidirektionalen Koaxial-Ausgangs-Anschluss 33. Das dritte Messgerät 3 verfügt über einen unidirektionalen Koaxial-Eingangs-Anschluss 34 und einen unidirektionalen Koaxial-Ausgangs-Anschluss 35.

Über den koaxialen Ausgangs-Anschluss 31, eine Koaxial-Leitung 36, und den Koaxial-Eingangs-Anschluss 32 ist das erste Messgerät 1 mit dem zweiten Messgerät 2 verbunden. Weiterhin ist über den Koaxial-Ausgangs-Anschluss 33, eine Leitung 37 und den Koaxial-Eingangs-Anschluss 34 das zweite Messgerät 2 mit dem dritten Messgerät 3 verbunden. Darüber hinaus ist über den Koaxial-Ausgangs-Anschluss 35, eine Leitung 38, und den Koaxial-Eingangs-Anschluss 30 das dritte Messgerät 3 mit dem ersten Messgerät 1 verbunden. So ergibt sich eine Ring-Topologie der Messgeräte 1 - 3. Auch so ist eine Kommunikation jedes Messgeräts 1 - 3 mit jedem anderen Messgerät 1 - 3 möglich.

Abschließend ist in Fig. 4 ein drittes Ausführungsbeispiel des Messsystems 49 gezeigt. Hier verfügen die Messgeräte 1 - 3 jeweils über zwei bidirektionale Anschlüsse 40 - 45. Jeweils der erste Anschluss 40, 42, 44 der Messgeräte 1 - 3 ist dabei mit einer gemeinsamen Leitung 47 verbunden. Jeweils die zweiten Anschlüsse 41, 43 und 45 der Messgeräte 1 - 3 sind mit einer weiteren Leitung 46 miteinander verbunden. Es sind somit zwei parallele Bus-Leitungen zwischen den Messgeräten 1 - 3 aufgebaut, über welche eine Informationsübertragung stattfinden kann.

Neben einer Verbindung der Messgeräte 1 - 3 mittels Koaxial-Leitungen ist auch eine direkte Verbindung der Messgeräte 1 - 3 möglich. In diesem Fall verfügt jedes einzelne Messgerät 1 - 3 über eine Anschluss-Schnittstelle, welche ausgebildet ist, um eine automatische Verbindung zu einem oder mehreren Leistungsmessgeräten herzustellen. Beispielsweise kann die Anschluss-Schnittstelle in einer Seitenwand des Gehäuses des jeweiligen Messgeräts angeordnet sein. Die miteinander zu verbindenden Messgeräte können dann nebeneinander angeordnet und durch Aneinanderschieben miteinander verbunden werden. Die entsprechenden Schnittstellen rasten dabei ineinander ein und stellen die Verbindung her.

Alternativ ist auch eine Verbindung der Messgeräte über eine Anschlussvorrichtung möglich. Diese könnte beispielsweise als Rückwand in einem Messgeräte-Schrank eingesetzt sein. Durch Einschieben des Messgeräts gegen die Rückwand kann eine Verbindung der Anschluss-Schnittstelle des jeweiligen Messgeräts mit der Anschlussvorrichtung erfolgen. Die Anschlussvorrichtung ist in diesem Fall ausgebildet, um mehrere Messgeräte auf diese Art und Weise miteinander zu verbinden.

Um nun eine Messung an einem Drehstromsystem mit mehreren Phasen, wie in Fig. 2 bis Fig. 4 dargestellt, durchzuführen, ist es insbesondere für hochgenaue Messungen des Phasenwinkels notwendig, eine Zeit-Synchronität zwischen den einzelnen Messgeräten 1 - 3 herzustellen. Dies kann beispielsweise dadurch erfolgen, dass ein Master-Messgerät eine Synchronisierungsnachricht an sämtliche Slave-Messgeräte überträgt. Die Slave-Messgeräte antworten auf die Synchronisierungsnachricht. Die Zeitdauer zwischen dem Aussenden der Synchronisierungsnachricht und dem Eintreffen der jeweiligen Antwort wird von dem Master-Messgerät gemessen. Die Hälfte dieser Zeit wird als Übertragungszeit der Synchronisierungsnachricht geschätzt. Es wird somit eine Übertragungsdauer von dem Master-Messgerät zu sämtlichen Slave-Messgeräten ermittelt. Diese Übertragungsdauern können zur zeitlichen Synchronisierung der Messergebnisse der einzelnen Messgeräte 1 - 3 herangezogen werden.

Alternativ kann in die Synchronisierungsnachricht auch zusätzlich ein Zeitstempel integriert werden. Die Antwort auf die Synchronisierungsnachricht beinhaltet in diesem Fall sowohl den Zeitstempel der Synchronisierungsnachricht, wie auch einen eigenen Zeitstempel. So lässt sich eine noch genauere Synchronisierung erreichen.

Die Erfindung ist somit nicht auf das dargestellte Ausführungsbeispiel beschränkt. Das Messsystem kann selbstverständlich auch mehr als drei Messgeräte beinhalten. Es ist dann geeignet auch in Mehrphasensystemen mit mehr als drei Phasen zu messen. Auch eine thermische Leistungsmessung oder eine andere Form von Leistungsmessung ist von der gegenwärtigen Erfindung abgedeckt. Über eine Verkabelung mit Koaxial-Leitungen und ein direktes Ineinanderstecken der Messgeräte bzw. der Anschlussvorrichtung hinaus ist auch eine Verbindung mit anderen Übertragungssystemen wie beispielsweise Ethernet, USB, Wi-Fi, Bluetooth, etc. denkbar. Alle vorstehend beschriebenen Merkmale oder in den Figuren gezeigte Merkmale sind im Rahmen der Erfindung beliebig vorteilhaft miteinander kombinierbar.

## Patentansprüche

1. Messsystem zur Messung der Leistung eines Mehrphasensystems, insbesondere eines Drehstromsystems, mit einem ersten Leistungsmessgerät (1) und zumindest einem zweiten Leistungsmessgerät (2),
wobei das erste Leistungsmessgerät (1)
- eine Messeinrichtung (10) zur Messung einer Leistung einer ersten Phase (L1) des Mehrphasensystems,
- eine Anzeigeeinrichtung (11) zur Darstellung von Messergebnissen,
- eine Bedieneinrichtung (12) zur Bedienung des Leistungsmessgeräts (1) durch einen Benutzer, und
- eine Kommunikationseinrichtung (13), welche ausgebildet ist, um mit dem zweiten Leistungsmessgerät (2) zu kommunizieren, aufweist,
wobei das zweite Leistungsmessgerät (2)
- eine Messeinrichtung zur Messung einer Leistung einer zweiten Phase (L2) des Mehrphasensystems, und
- eine Kommunikationseinrichtung, welche ausgebildet ist, um mit dem ersten Leistungsmessgerät (1) zu kommunizieren, aufweist,
wobei die Kommunikationseinrichtung (13) des ersten Leistungsmessgeräts (1) und die Kommunikationseinrichtung des zweiten Leistungsmessgeräts (2) miteinander verbunden sind,
wobei die Kommunikationseinrichtung (13) des ersten Leistungsmessgeräts (1) und die Kommunikationseinrichtung des zweiten Leistungsmessgeräts (2) ausgebildet sind, um miteinander zu kommunizieren,
**dadurch gekennzeichnet,**
**dass** das zweite Leistungsmessgerät (2)
- eine Anzeigeeinrichtung zur Darstellung von Messergebnissen, und
- eine Bedieneinrichtung zur Bedienung des zweiten Leistungsmessgeräts (2) durch einen Benutzer aufweist,
und dadurch dass das erste Leistungsmessgerät (1) und das zweite Leistungsmessgerät (2) ausgebildet sind, um gemeinsam eine Leistung auf zumindest zwei Phasen (L1, L2) des Mehrphasensystems, insbesondere Drehstromsystems, zu messen.

2. Messsystem nach Anspruch 1,
**dadurch gekennzeichnet,**
**dass** das erste Leistungsmessgerät (1) in einem Master-Modus betreibbar ist, in welchem das erste Leistungsmessgerät (1) das zweite Leistungsmessgerät (2) steuert,
**dass** das erste Leistungsmessgerät (1) in einem Slave-Modus betreibbar ist, in welchem das erste Leistungsmessgerät (1) von dem zweiten Leistungsmessgerät (2) gesteuert wird, dass das zweite Leistungsmessgerät (2) in einem Master-Modus betreibbar ist, in welchem das zweite Leistungsmessgerät (2) das erste Leistungsmessgerät (2) steuert, und
**dass** das zweite Leistungsmessgerät (2) in einem Slave-Modus betreibbar ist, in welchem das zweite Leistungsmessgerät (2) von dem ersten Leistungsmessgerät (1) gesteuert wird.

3. Messsystem nach Anspruch 2,
**dadurch gekennzeichnet,**
**dass** das erste Leistungsmessgerät (1) ausgebildet ist, um im Master-Modus
- Messergebnisse von dem zweiten Leistungsmessgerät (2) mittels der Kommunikationseinrichtung (13) zu empfangen, und/oder
- Messergebnisse des ersten Leistungsmessgeräts (1) und des zweiten Leistungsmessgeräts (2) auf der Anzeigeeinrichtung (11) des ersten Leistungsmessgeräts (1) darzustellen, und/oder
- Bedieneingaben für das erste Leistungsmessgerät (1) und das zweite Leistungsmessgerät (2) mittels der Bedieneinrichtung (12) des ersten Leistungsmessgeräts (1) entgegenzunehmen und zu verarbeiten,
**dass** das erste Leistungsmessgerät (1) ausgebildet ist, um im Slave-Modus
- Messergebnisse an das zweite Leistungsmessgerät (2) mittels der Kommunikationseinrichtung (13) zu übertragen, und/oder
- keine Messergebnisse auf der Anzeigeeinrichtung (11) des ersten Leistungsmessgeräts (1) darzustellen, und/oder
- keine Bedieneingaben mittels der Bedieneinrichtung (12) des ersten Leistungsmessgeräts (1) entgegenzunehmen und zu verarbeiten,
**dass** das zweite Leistungsmessgerät (2) ausgebildet ist, um im Master-Modus
- Messergebnisse von dem ersten Leistungsmessgerät (1) mittels der Kommunikationseinrichtung zu empfangen, und/oder
- Messergebnisse des zweiten Leistungsmessgeräts (2) und des ersten Leistungsmessgeräts (1) auf der Anzeigeeinrichtung des zweiten Leistungsmessgeräts (2) darzustellen, und/oder
- Bedieneingaben für das zweite Leistungsmessgerät (2) und das erste Leistungsmessgerät (1) mittels der Bedieneinrichtung des zweiten Leistungsmessgeräts (2) entgegenzunehmen und zu verarbeiten, und
**dass** das zweite Leistungsmessgerät (2) ausgebildet ist, um im Slave-Modus
- Messergebnisse an das erste Leistungsmessgerät (1) mittels der Kommunikationseinrichtung zu übertragen, und/oder
- keine Messergebnisse auf der Anzeigeeinrichtung des zweiten Leistungsmessgeräts (2) darzustellen, und/oder
- keine Bedieneingaben mittels der Bedieneinrichtung des zweiten Leistungsmessgeräts (2) entgegenzunehmen und zu verarbeiten.

4. Messsystem nach einem der Ansprüche 1 bis 3,
**dadurch gekennzeichnet,**
**dass** die Messeinrichtung (10) des ersten Leistungsmessgeräts (1) ausgebildet ist, um einen Strom (I1) und eine Spannung (U1) auf der ersten Phase (L1) zu messen und die Leistung der ersten Phase (L1) aus dem Strom (I1) und der Spannung (U1) auf der ersten Phase (L1) zu berechnen, und
**dass** die Messeinrichtung des zweiten Leistungsmessgeräts (2) ausgebildet ist, um einen Strom (I2) und eine Spannung (U2) auf der zweiten Phase (L2) zu messen und die Leistung der zweiten Phase (L2) aus dem Strom (I2) und der Spannung (U2) auf der zweiten Phase (L2) zu berechnen.

5. Messsystem nach einem der Ansprüche 1 bis 4,
**dadurch gekennzeichnet,**
**dass** die Kommunikationseinrichtung (13) des ersten Leistungsmessgeräts (1) ausgebildet ist, um an einen seriellen oder parallelen oder ringförmigen Kommunikationsbus (26, 27, 28, 36, 37, 46, 47) angeschlossen zu werden und mittels des Kommunikationsbus mit dem zweiten Leistungsmessgerät (2) zu kommunizieren, und
**dass** die Kommunikationseinrichtung des zweiten Leistungsmessgeräts (2) ausgebildet ist, um an einen seriellen oder parallelen oder ringförmigen Kommunikationsbus (26, 27, 28, 36, 37, 46, 47) angeschlossen zu werden und mittels des Kommunikationsbus mit dem ersten Leistungsmessgerät (1) zu kommunizieren.

6. Messsystem nach einem der Ansprüche 1 bis 5,
**dadurch gekennzeichnet,**
**dass** die Kommunikationseinrichtung (13) des ersten Leistungsmessgeräts (1) über einen bidirektionalen digitalen Koaxial-Anschluss (20, 21, 22, 23, 24, 25, 40, 41, 42, 43, 44, 45) verfügt,
**dass** die Kommunikationseinrichtung (13) des ersten Leistungsmessgeräts (1) ausgebildet ist, um mittels des bidirektionalen digitalen Koaxial-Anschlusses (20, 21, 22, 23, 24, 25, 40, 41, 42, 43, 44, 45) mit dem zweiten Leistungsmessgerät (2) verbunden zu werden,
**dass** die Kommunikationseinrichtung des zweiten Leistungsmessgeräts (2) über einen bidirektionalen digitalen Koaxial-Anschluss (20, 21, 22, 23, 24, 25, 40, 41, 42, 43, 44, 45) verfügt, und
**dass** die Kommunikationseinrichtung (13) des zweiten Leistungsmessgeräts (2) ausgebildet ist, um mittels des bidirektionalen digitalen Koaxial-Anschlusses (20, 21, 22, 23, 24, 25, 40, 41, 42, 43, 44, 45) mit dem ersten Leistungsmessgerät (1) verbunden zu werden,
oder
**dass** die Kommunikationseinrichtung (13) des ersten Leistungsmessgeräts (1) über einen unidirektionalen digitale Koaxial-Eingangs-Anschluss (30, 32, 34) und einen unidirektionalen digitalen Koaxial-Ausgangs-Anschluss (31, 33, 35) verfügt,
**dass** die Kommunikationseinrichtung (13) des ersten Leistungsmessgeräts (1) ausgebildet ist, um mittels des unidirektionalen digitale Koaxial-Eingangs-Anschlusses (30, 32, 34) und des unidirektionalen digitale Koaxial-Ausgangs-Anschlusses (31, 33, 35) mit dem zweiten Leistungsmessgerät (2) verbunden zu werden,
**dass** die Kommunikationseinrichtung des zweiten Leistungsmessgeräts (2) über einen unidirektionalen digitalen Koaxial-Eingangs-Anschluss (30, 32, 34) und einen unidirektionalen digitalen Koaxial-Ausgangs-Anschluss (31, 33, 35) verfügt, und
**dass** die Kommunikationseinrichtung des zweiten Leistungsmessgeräts (2) ausgebildet ist, um mittels des unidirektionalen digitale Koaxial-Eingangs-Anschlusses (30, 32, 34) und des unidirektionalen digitale Koaxial-Ausgangs-Anschlusses (31, 33, 35) mit dem ersten Leistungsmessgerät (1) verbunden zu werden.

7. Messsystem nach einem der Ansprüche 1 bis 6,
**dadurch gekennzeichnet,**
**dass** die Kommunikationseinrichtung (13) des ersten Leistungsmessgeräts (1) über eine Anschluss-Schnittstelle verfügt,
**dass** die Kommunikationseinrichtung des zweiten Leistungsmessgeräts (2) über eine Anschluss-Schnittstelle verfügt,
**dass** die Anschlussschnittstellen ausgebildet sind, um eine automatische Verbindung zwischen dem ersten Leistungsmessgerät (1) und dem zweiten Leistungsmessgerät (2)
- direkt bei einem Aneinanderstecken des Leistungsmessgeräts (1, 2, 3) und des zweiten Leistungsmessgeräts (2), oder
- indirekt mittels einer Anschlussvorrichtung bei einem Aneinanderstecken des ersten Leistungsmessgeräts (1) und der Anschlussvorrichtung, und einem Aneinanderstecken des zweiten Leistungsmessgeräts (2) und der Anschlussvorrichtung,
herzustellen.

8. Messsystem nach einem der Ansprüche 1 bis 7,
**dadurch gekennzeichnet,**
**dass** die Kommunikationseinrichtungen des ersten Leistungsmessgeräts (1) und des zweiten Leistungsmessgeräts (2) ausgebildet sind,
- um eine Synchronisierung des ersten Leistungsmessgeräts (1) und des zweiten Leistungsmessgeräts (2) zur phasenkohärenten Messung durchzuführen, und/oder
- um Messergebnisse zu übertragen, und/oder
- um Steuerbefehle zu übertragen.

9. Messsystem nach Anspruch 8,
**dadurch gekennzeichnet,**
**dass** die Kommunikationseinrichtung (13) des ersten Leistungsmessgeräts (1) ausgebildet ist, um zur Synchronisierung des ersten Leistungsmessgeräts (1) und des zweiten Leistungsmessgeräts (2)
- eine Synchronisierungsnachricht an das zweite Leistungsmessgerät (2) zu senden,
- eine Zeitdauer bis zum Eintreffen einer Antwort des zweiten Leistungsmessgeräts (2) zu bestimmen, und
- die Hälfte der Zeitdauer bis zum Eintreffen der Antwort des zweiten Leistungsmessgeräts (2) als Übertragungszeit der Synchronisierungsnachricht zu schätzen,
**dass** die Messeinrichtung (10) des ersten Leistungsmessgeräts (1) ausgebildet ist, um bei einer Verarbeitung der Messergebnisse des zweiten Leistungsmessgeräts (2), die geschätzte Übertragungszeit der Synchronisierungsnachricht als Verzögerung einer Übertragung von Steuerbefehlen und Messergebnissen zu berücksichtigen,
**dass** die Kommunikationseinrichtung des zweiten Leistungsmessgeräts (2) ausgebildet ist, um zur Synchronisierung des zweiten Leistungsmessgeräts (2) und des ersten Leistungsmessgeräts (1)
- eine Synchronisierungsnachricht an das erste Leistungsmessgerät (1) zu senden,
- eine Zeitdauer bis zum Eintreffen einer Antwort des ersten Leistungsmessgeräts (1) zu bestimmen, und
- die Hälfte der Zeitdauer bis zum Eintreffen der Antwort des ersten Leistungsmessgeräts (1) als Übertragungszeit der Synchronisierungsnachricht zu schätzen, und
**dass** die Messeinrichtung des zweiten Leistungsmessgeräts (2) ausgebildet ist, um bei einer Verarbeitung der Messergebnisse des ersten Leistungsmessgeräts (1), die geschätzte Übertragungszeit der Synchronisierungsnachricht als Verzögerung einer Übertragung von Steuerbefehlen und Messergebnissen zu berücksichtigen.

10. Messsystem nach einem der Ansprüche 1 bis 9,
**dadurch gekennzeichnet,**
**dass** die Kommunikationseinrichtung (13) des ersten Leistungsmessgeräts (1) ausgebildet ist, um mit zumindest zwei, insbesondere zwei, oder drei, oder vier, oder fünf, oder sechs, oder sieben, oder acht, oder neun, oder zehn weiteren Leistungsmessgeräten (1, 2, 3) zu kommunizieren, dass das erste Leistungsmessgerät (1) ausgebildet ist, um gemeinsam mit den weiteren Leistungsmessgeräten (1, 2, 3) eine Leistung auf weiteren Phasen (L1, L2, L3) des Mehrphasensystems, insbesondere Drehstromsystems, zu messen,
**dass** die Kommunikationseinrichtung des zweiten Leistungsmessgeräts (2) ausgebildet ist, um mit zumindest zwei, insbesondere zwei, oder drei, oder vier, oder fünf, oder sechs, oder sieben, oder acht, oder neun, oder zehn weiteren Leistungsmessgeräten (1, 2, 3) zu kommunizieren, und
**dass** das zweite Leistungsmessgerät (2) ausgebildet ist, um gemeinsam mit den weiteren Leistungsmessgeräten (1, 2, 3) eine Leistung auf weiteren Phasen (L1, L2, L3) des Mehrphasensystems, insbesondere Drehstromsystems, zu messen.

11. Messsystem nach einem der Ansprüche 2 oder 3,
**dadurch gekennzeichnet,**
**dass** das erste Leistungsmessgerät (1) ausgebildet ist, um im Master-Modus zu arbeiten, und
**dass** das zumindest eine zweite Leistungsmessgerät (2, 3) ausgebildet ist, um im Slave-Modus zu arbeiten.

12. Messsystem nach Anspruch 11,
**dadurch gekennzeichnet,**
**dass** das Messsystem (29, 39, 49) über zumindest zwei, bevorzugt zwei, oder drei, oder vier, oder fünf, oder sechs, oder sieben, oder acht, oder neun, oder zehn zweite Leistungsmessgeräte (2, 3) verfügt,
**dass** jedes zweite Leistungsmessgerät (2, 3) ausgebildet ist, um eine Leistung auf einer unterschiedlichen Phase (L2, L3) des Mehrphasensystems, insbesondere Drehstromsystems, zu messen, und
**dass** das erste Leistungsmessgerät (1) und die zweiten Leistungsmessgeräte (2, 3) ausgebildet sind, um gemeinsam die Leistung auf einer Mehrzahl an Phasen (L1, L2, L3), bevorzugt auf sämtlichen Phasen (L1, L2, L3) des Mehrphasensystems zu messen.

13. Messsystem nach Anspruch 9,
**dadurch gekennzeichnet,**
**dass** das erste Leistungsmessgerät (1) ausgebildet ist, um die Synchronisierungsnachricht an das zumindest eine zweite Leistungsmessgerät (2, 3) zu senden, und
**dass** das zumindest eine zweite Leistungsmessgerät (2, 3) ausgebildet ist, um eine Antwort auf die Synchronisierungsnachricht an das erste Leistungsmessgerät (1) zu senden, sobald es die Synchronisierungsnachricht empfangen hat.

14. Messsystem nach einem der Ansprüche 10 bis 13,
**dadurch gekennzeichnet,**
**dass** das Messsystem (29, 39, 49) über Messleitungen identischer Länge zum Anschluss des ersten Leistungsmessgeräts (1) und des zumindest einen zweiten Leistungsmessgeräts (2, 3) an die Phasen (L1, L2, L3) des Mehrphasensystems, insbesondere Drehstromsystems, verfügt.

15. Messsystem nach Anspruch 7,
**dadurch gekennzeichnet,**
**dass** das Messsystem (29, 39, 49) über eine Anschlussvorrichtung zur automatischen Verbindung der Leistungsmessgeräte (1, 2, 3) bei einem Aneinanderstecken des jeweiligen Leistungsmessgeräts (1, 2, 3) und der Anschlussvorrichtung, verfügt.

## Claims

1. Measuring system for measuring the power of a multiphase system, in particular a three-phase system, with a first power measuring device (1) and at least one second power measuring device (2),
wherein the first power measuring device (1) comprises
- a measuring unit (10) for measuring a power of a first phase (L1) of the multiphase system,
- a display unit (11) for displaying measurement results,
- an operating unit (12) for operation of the power measuring device (1) by a user, and
- a communications unit (13) which is configured to communicate with the second power measuring device (2), wherein the second power measuring device (2) comprises
- a measuring unit for measuring a power of a second phase (L2) of the multiphase system,
- a communications unit which is configured to communicate with the first power measuring device (1),
wherein the communications unit (13) of the first power measuring device (1) and the communications unit of the second power measuring device (2) are connected with one another,
wherein the communications unit (13) of the first power measuring device (1) and the communications unit of the second power measuring device (2) are configured to communicate with one another,
**characterised in that**
the second power measuring device (2) comprises
- a display unit for displaying measurement results, and
- an operating unit for operation of the second power measuring device (2) by a user, and
**in that** the first power measuring device (1) and the second power measuring device (2) are configured jointly to measure a power on at least two phases (L1, L2) of the multiphase system, in particular the three-phase system.

2. Measuring system according to claim 1,
**characterised in that**
the first power measuring device (1) can be operated in a master mode in which the first power measuring device (1) controls the second power measuring device (2),
**in that** the first power measuring device (1) can be operated in a slave mode in which the first power measuring device (1) is controlled by the second power measuring device (2),
**in that** the second power measuring device (2) can be operated in a master mode in which the second power measuring device (2) controls the first power measuring device (1), and
**in that** the second power measuring device (2) can be operated in a slave mode in which the second power measuring device (2) is controlled by the first power measuring device (1).

3. Measuring system according to claim 2,
**characterised in that**
the first power measuring device (1) is configured in the master mode
- to receive measurement results from the second power measuring device (2) by means of the communications unit (13), and/or
- to display measurement results of the first power measuring device (1) and the second power measuring device (2) on the display unit (11) of the first power measuring device (1), and/or
- to accept and to process operating inputs for the first power measuring device (1) and the second power measuring device (2) by means of the operating unit (12) of the first power measuring device (1),
**in that** the first power measuring device (1) is configured in the slave mode
- to transmit measurement results to the second power measuring device (2) by means of the communications unit (13), and/or
- to display no measurement results on the display unit (11) of the first power measuring device (1), and/or
- to accept and to process no operating inputs by means of the operating unit (12) of the first power measuring device (1),
**in that** the second power measuring device (2) is configured in the master mode
- to receive measurement results from the first power measuring device (1) by means of the communications unit,
and/or
- to display measurement results of the second power measuring device (2) and the first power measuring device (1) on the display unit of the second power measuring device (2), and/or
- to accept and to process operating inputs for the second power measuring device (2) and the first power measuring device (1) by means of the operating unit of the second power measuring device (2), and
**in that** the second power measuring device (2) is configured in the slave mode
- to transmit measurement results to the first power measuring device (1) by means of the communications unit,
and/or
- to display no measurement results on the display unit of the second power measuring device (2), and/or
- to accept and to process no operating inputs by means of the operating unit of the second power measuring device (2).

4. Measuring system according to one of claims 1 to 3, **characterised in that**
the measuring unit (10) of the first power measuring device (1) is configured to measure a current (II) and a voltage (U1) on the first phase (L1) and to calculate the power of the first phase (L1) from the current (II) and the voltage (U1) on the first phase (L1), and
**in that** the measuring unit of the second power measuring device (2) is configured to measure a current (12) and a voltage (U2) on the second phase (L2) and to calculate the power of the second phase (L2) from the current (12) and the voltage (U2) on the second phase (L2).

5. Measuring system according to one of claims 1 to 4, **characterised in that**
the communications unit (13) of the first power measuring device (1) is configured to be connected to a serial or parallel or annular communications bus (26, 27, 28, 36, 37, 46, 47) and to communicate with the second power measuring device (2) by means of the communications bus (2), and
**in that** the communications unit of the second power measuring device (2) is configured to be connected to a serial or parallel or annular communications bus (26, 27, 28, 36, 37, 46, 47) and to communicate with the first power measuring device (1) by means of the communications bus.

6. Measuring system according to one of claims 1 to 5, **characterised in that**
the communications unit (13) of the first power measuring device (1) has a bidirectional digital coaxial connector (20, 21, 22, 23, 24, 25, 40, 41, 42, 43, 44, 45),
**in that** the communications unit (13) of the first power measuring device (1) is configured to be connected with the second power measuring device (2) by means of the bidirectional digital coaxial connector (20, 21, 22, 23, 24, 25, 40, 41, 42, 43, 44, 45),
**in that** the communications unit of the second power measuring device (2) has a bidirectional digital coaxial connector (20, 21, 22, 23, 24, 25, 40, 41, 42, 43, 44, 45), and
**in that** the communications unit (13) of the second power measuring device (2) is configured to be connected with the first power measuring device (1) by means of the bidirectional digital coaxial connector (20, 21, 22, 23, 24, 25, 40, 41, 42, 43, 44, 45), or
**in that** the communications unit (13) of the first power measuring device (1) has a unidirectional digital coaxial input connector (30, 32, 34) and a unidirectional digital coaxial output connector (31, 33, 35),
**in that** the communications unit (13) of the first power measuring device (1) is configured to be connected with the second power measuring device (2) by means of the unidirectional digital coaxial input connector (30, 32, 34) and the unidirectional digital coaxial output connector (31, 33, 35),
**in that** the communications unit of the second power measuring device (2) has a unidirectional digital coaxial input connector (30, 32, 34) and a unidirectional digital coaxial output connector (31, 33, 35), and
**in that** the communications unit of the second power measuring device (2) is configured to be connected with the first power measuring device (1) by means of the unidirectional digital coaxial input connector (30, 32, 34) and the unidirectional digital coaxial output connector (31, 33, 35).

7. Measuring system according to one of claims 1 to 6, **characterised in that**
the communications unit (13) of the first power measuring device (1) has a connector interface,
**in that** the communications unit of the second power measuring device (2) has a connector interface,
**in that** the connector interfaces are configured to produce an automatic connection between the first power measuring device (1) and the second power measuring device (2)
- directly when the power measuring device (1, 2, 3) and the power measuring device (2) are plugged together, or
- indirectly by means of a connector device when the first power measuring device (1) and the connector device are plugged together, and the second power measuring device (2) and the connector device are plugged together.

8. Measuring system according to one of claims 1 to 7, **characterised in that**
the communications units of the first power measuring device (1) and of the second power measuring device (2) are configured
- to carry out synchronisation of the first power measuring device (1) and the second power measuring device (2) for phase-coherent measurement, and/or
- to transmit measurement results, and/or
- to transmit control commands.

9. Measuring system according to claim 8, **characterised in that**
the communications unit (13) of the first power measuring device (1) is configured for synchronisation of the first power measuring device (1) and the second power measuring device (2) to
- send a synchronising message to the second power measuring device (2),
- to determine a period of time for reception of a response from the second power measuring device (2), and
- to estimate half the period of time for reception of the response from the second power measuring device (2) as the time for transmission of the synchronising message,
**in that** the measuring unit (10) of the first power measuring device (1) is configured when the measurement results of the second power measuring device (2) are processed to regard the estimated transmission time of the synchronising message as the delay in transmission of control commands and measurement results,
**in that** the communications unit of the second power measuring device (2) is configured for synchronisation of the second power measuring device (2) and the first power measuring device (1) to
- send a synchronising message to the first power measuring device (1),
- to determine a period of time for reception of a response from the first power measuring device (1), and
- to estimate half the period of time for reception of the response from the first power measuring device (1) as the time for transmission of the synchronising message, and
**in that** the measuring unit of the second power measuring device (2) is configured when the measurement results of the first power measuring device (1) are processed to regard the estimated transmission time of the synchronising message as the delay in transmission of control commands and measurement results.

10. Measuring system according to one of claims 1 to 9, **characterised in that**
the communications unit (13) of the first power measuring device (1) is configured to communicate with at least two, in particular two, or three, or four, or five, or six, or seven, or eight, or nine, or ten further power measuring devices (1, 2, 3),
**in that** the first power measuring device (1) is configured jointly with the further power measuring devices (1, 2, 3) to measure a power on further phases (L1, L2, L3) of the multiphase system, in particular the three-phase system,
**in that** the communications unit of the second power measuring device (2) is configured to communicate with at least two, in particular two, or three, or four, or five, or six, or seven, or eight, or nine, or ten further power measuring devices (1, 2, 3), and
**in that** the second power measuring device (2) is configured jointly with the further power measuring devices (1, 2, 3) to measure a power on further phases (L1, L2, L3) of the multiphase system, in particular the three-phase system.

11. Measuring system according to one of claims 2 or 3, **characterised in that**
the first power measuring device (1) is configured to work in the master mode, and
**in that** the at least one second power measuring device (2, 3) is configured to work in the slave mode.

12. Measuring system according to claim 11, **characterised in that**
the measuring system (29, 39, 49) has at least two, preferably two, or thee, or four, or five, or six, or seven, or eight, or nine, or ten second power measuring devices (2, 3),
**in that** each second power measuring device (2, 3) is configured to measure a power on a different phase (L2, L3) of the multiphase system, in particular the three-phase system, and
**in that** the first power measuring device (1) and the second power measuring devices (2, 3) are configured jointly to measure the power on a plurality of phases (L1, L2, L3), preferably on all of the phases (L1, L2, L3) of the multiphase system.

13. Measuring system according to claim 9, **characterised in that**
the first power measuring device (1) is configured to send the synchronising message to the at least one second power measuring device (2, 3), and
**in that** the at least one second power measuring device (2, 3) is configured to send a response to the synchronising message to the first power measuring device (1) as soon as it has received the synchronising message.

14. Measuring system according to one of claims 10 to 13,
**characterised in that**
the measuring system (29, 39, 49) has measuring lines of identical length to the connector of the first power measuring device (1) and of the at least one second power measuring device (2, 3) to the phases (L1, L2, L3) of the multiphase system, in particular the three-phase system.

15. Measuring system according to claim 7,
**characterised in that**
the measuring system (29, 39, 49) has a connector device for automatic connection of the power measuring devices (1, 2, 3) when the respective power measuring device (1, 2, 3) and the connector device are plugged together.

## Revendications

1. Système de mesure destiné à mesurer la puissance d'un système polyphasé, en particulier d'un système de courant triphasé, comprenant un premier appareil de mesure de puissance (1) et au moins un deuxième appareil de mesure de puissance (2),
dans lequel le premier appareil de mesure de puissance (1) comprend
- un dispositif de mesure (10) destiné à mesurer une puissance d'une première phase (L1) du système polyphasé,
- un dispositif d'affichage (11) destiné à représenter les résultats de la mesure,
- un dispositif de commande (12) destiné à commander l'appareil de mesure de puissance (1) par l'intermédiaire d'un utilisateur, et
- un dispositif de communication (13), lequel est conçu pour communiquer avec le deuxième appareil de mesure de puissance (2),
dans lequel le deuxième appareil de mesure de puissance (2) comprend
- un dispositif de mesure destiné à mesurer une puissance d'une deuxième phase (L2) du système polyphasé,
- un dispositif de communication, lequel est conçu pour communiquer avec le premier appareil de mesure de puissance (1),
dans lequel le dispositif de communication (13) du premier appareil de mesure de puissance (2) et le dispositif de communication du deuxième appareil de mesure de puissance (2) sont reliés l'un à l'autre,
dans lequel le dispositif de communication (13) du premier appareil de mesure de puissance (1) et le dispositif de communication du deuxième appareil de mesure de puissance (2) sont conçus pour communiquer l'un avec l'autre,
**caractérisé**
**en ce que** le deuxième appareil de mesure de puissance (2) comprend
- un dispositif d'affichage destiné à représenter les résultats de la mesure, et
- un dispositif de commande destiné à commander le deuxième appareil de mesure de puissance (2) par l'intermédiaire d'un utilisateur, et en ce que le premier appareil de mesure de puissance (1) et le deuxième appareil de mesure de puissance (2) sont conçus pour mesurer conjointement une puissance sur au moins deux phases (L1, L2) du système polyphasé, en particulier du système triphasé.

2. Système de mesure selon la revendication 1,
**caractérisé**
**en ce que** le premier appareil de mesure de puissance (1) peut fonctionner dans un mode maître, dans lequel le premier appareil de mesure de puissance (1) commande le deuxième appareil de mesure de puissance (2),
**en ce que** le premier appareil de mesure de puissance (1) peut fonctionner dans un mode esclave, dans lequel le premier appareil de mesure de puissance (1) est commandé par le deuxième appareil de mesure de puissance (2),
**en ce que** le deuxième appareil de mesure de puissance (2) peut fonctionner dans un mode maître, dans lequel le deuxième appareil de mesure de puissance (2) commande le premier appareil de mesure de puissance (1), et
**en ce que** le deuxième appareil de mesure de puissance (2) peut fonctionner dans un mode esclave, dans lequel le deuxième appareil de mesure de puissance (2) est commandé par le premier appareil de mesure de puissance (1).

3. Système de mesure selon la revendication 2,
**caractérisé**
**en ce que** le premier appareil de mesure de puissance (1) est conçu, dans le mode maître,
- pour recevoir des résultats de la mesure du deuxième appareil de mesure de puissance (2) au moyen du dispositif de communication (13), et/ou
- pour représenter les résultats de la mesure du premier appareil de mesure de puissance (1) et du deuxième appareil de mesure de puissance (2) sur le dispositif d'affichage (11) du premier appareil de mesure de puissance (1), et/ou
- pour accepter et pour traiter des entrées de commande pour le premier appareil de mesure de puissance (1) et le deuxième appareil de mesure de puissance (2) au moyen du dispositif de commande (12) du premier appareil de mesure de puissance (1),
**en ce que** le premier appareil de mesure de puissance (1) est conçu, dans le mode esclave,
- pour transmettre les résultats de la mesure au deuxième appareil de mesure de puissance (2) au moyen du dispositif de communication (13), et/ou
- pour ne représenter aucun résultat de la mesure sur le dispositif d'affichage (11) du premier appareil de mesure de puissance (1), et/ou
- pour n'accepter et pour ne traiter aucune entrée de commande au moyen du dispositif de commande (12) du premier appareil de mesure de puissance (1),
**en ce que** le deuxième appareil de mesure de puissance (2) est conçu, dans le mode maître,
- pour recevoir les résultats de la mesure du premier appareil de mesure de puissance (1) au moyen du dispositif de communication, et/ou
- pour représenter les résultats de la mesure du deuxième appareil de mesure de puissance (2) et du premier appareil de mesure de puissance (1) sur le dispositif d'affichage du deuxième appareil de mesure de puissance (2), et/ou
- pour accepter et traiter des entrées de commande pour le deuxième appareil de mesure de puissance (2) et le premier appareil de mesure de puissance (1) au moyen du dispositif de commande du deuxième appareil de mesure de puissance (2), et en ce que le deuxième appareil de mesure de puissance (2) est conçu, en mode esclave,
- pour transmettre les résultats de la mesure au premier appareil de mesure de puissance (1) au moyen du dispositif de communication, et/ou
- pour ne représenter aucun résultat de la mesure sur le dispositif d'affichage du deuxième appareil de mesure de puissance (2), et/ou
- pour n'accepter et ne traiter aucune entrée de commande au moyen du dispositif de commande du deuxième appareil de mesure de puissance (2).

4. Système de mesure selon l'une quelconque des revendications 1 à 3,
**caractérisé**
**en ce que** le dispositif de mesure (10) du premier appareil de mesure de puissance (1) est conçu pour mesurer un courant (I1) et une tension (U1) sur la première phase (L1) et pour calculer la puissance de la première phase (L1) à partir du courant (I1) et de la tension (U1) sur la première phase (L1), et
**en ce que** le dispositif de mesure du deuxième appareil de mesure de puissance (2) est conçu pour mesurer un courant (I2) et une tension (U2) sur la deuxième phase (L2) et pour calculer la puissance de la deuxième phase (L2) à partir du courant (I2) et de la tension (U2) sur la deuxième phase (L2).

5. Système de mesure selon l'une quelconque des revendications 1 à 4,
**caractérisé**
**en ce que** le dispositif de communication (13) du premier appareil de mesure de puissance (1) est conçu pour être raccordé à un bus de communication (26, 27, 28, 36, 37, 46, 47) série ou parallèle ou annulaire et pour communiquer avec le deuxième appareil de mesure de puissance (2) au moyen du bus de communication, et
**en ce que** le dispositif de communication du deuxième appareil de mesure de puissance (2) est conçu pour être raccordé à un bus de communication (26, 27, 28, 36, 37, 46, 47) série ou parallèle ou annulaire et pour communiquer avec le premier appareil de mesure de puissance (1) au moyen du bus de communication.

6. Système de mesure selon l'une quelconque des revendications 1 à 5,
**caractérisé**
**en ce que** le dispositif de communication (13) du premier appareil de mesure de puissance (1) dispose d'un raccordement coaxial numérique bidirectionnel (20, 21, 22, 23, 24, 25, 40, 41, 42, 43, 44, 45),
**en ce que** le dispositif de communication (13) du premier appareil de mesure de puissance (1) est conçu pour être relié au deuxième appareil de mesure de puissance (2) au moyen du raccordement coaxial numérique bidirectionnel (20, 21, 22, 23, 24, 25, 40, 41, 42, 43, 44, 45),
**en ce que** le dispositif de communication du deuxième appareil de mesure de puissance (2) dispose d'un raccordement coaxial numérique bidirectionnel (20, 21, 22, 23, 24, 25, 40, 41, 42, 43, 44, 45), et
**en ce que** le dispositif de communication (13) du deuxième appareil de mesure de puissance (2) est conçu pour être relié au premier appareil de mesure de puissance (1) au moyen du raccordement coaxial numérique bidirectionnel (20, 21, 22, 23, 24, 25, 40, 41, 42, 43, 44, 45),
ou
**en ce que** le dispositif de communication (13) du premier appareil de mesure de puissance (1) dispose d'un raccordement d'entrée coaxial numérique unidirectionnel (30, 32, 34) et d'un raccordement de sortie coaxial numérique unidirectionnel (31, 33, 35),
**en ce que** le dispositif de communication (13) du premier appareil de mesure de puissance (1) est conçu pour être relié au deuxième appareil de mesure de puissance (2) au moyen du raccordement d'entrée coaxial numérique unidirectionnel (30, 32, 34) et du raccordement de sortie coaxial numérique unidirectionnel (31, 33, 35),
**en ce que** le dispositif de communication du deuxième appareil de mesure de puissance (2) dispose d'un raccordement d'entrée coaxial numérique unidirectionnel (30, 32, 34) et d'un raccordement de sortie coaxial numérique unidirectionnel (31, 33, 35), et
**en ce que** le dispositif de communication du deuxième appareil de mesure de puissance (2) est conçu pour être relié au premier appareil de mesure de puissance (1) au moyen du raccordement d'entrée coaxial numérique unidirectionnel (30, 32, 34) et du raccordement de sortie coaxial numérique unidirectionnel (31, 33, 35).

7. Système de mesure selon l'une quelconque des revendications 1 à 6,
**caractérisé**
**en ce que** le dispositif de communication (13) du premier appareil de mesure de puissance (1) dispose d'une interface de raccordement,
**en ce que** le dispositif de communication du deuxième appareil de mesure de puissance (2) dispose d'une interface de raccordement,
**en ce que** les interfaces de raccordement sont conçues pour établir une liaison automatique entre le premier appareil de mesure de puissance (1) et le deuxième appareil de mesure de puissance (2),
- de façon directe, lorsque l'appareil de mesure de puissance (1, 2, 3) et le deuxième appareil de mesure de puissance (2) sont branchés l'un à l'autre, ou
- de façon indirecte, au moyen d'un dispositif de raccordement, lorsque le premier appareil de mesure de puissance (1) et le dispositif de raccordement sont branchés l'un à l'autre, et lorsque le deuxième appareil de mesure de puissance (2) et le dispositif de raccordement sont branchés l'un à l'autre.

8. Système de mesure selon l'une quelconque des revendications 1 à 7,
**caractérisé**
**en ce que** les dispositifs de communication du premier appareil de mesure de puissance (1) et du deuxième appareil de mesure de puissance (2) sont conçus
- pour réaliser une synchronisation du premier appareil de mesure de puissance (1) et du deuxième appareil de mesure de puissance (2) aux fins d'une mesure avec cohérence de phases, et/ou
- pour transmettre les résultats de la mesure, et/ou
- pour transmettre des instructions de commande.

9. Système de mesure selon la revendication 8,
**caractérisé**
**en ce que** le dispositif de communication (13) du premier appareil de mesure de puissance (1) est conçu, pour la synchronisation du premier appareil de mesure de puissance (1) et du deuxième appareil de mesure de puissance (2),
- pour envoyer un message de synchronisation au deuxième appareil de mesure de puissance (2),
- pour déterminer une durée jusqu'à l'arrivée d'une réponse du deuxième appareil de mesure de puissance (2), et
- pour estimer la moitié de la durée jusqu'à l'arrivée de la réponse du deuxième appareil de mesure de puissance (2) en tant que temps de transmission du message de synchronisation, en ce que le dispositif de mesure (10) du premier appareil de mesure de puissance (1) est conçu pour prendre en compte, dans le cas d'un traitement des résultats de la mesure du deuxième appareil de mesure de puissance (2), le temps de transmission estimé du message de synchronisation en tant que retard d'une transmission d'instructions de commande et des résultats de la mesure,
**en ce que** le dispositif de communication du deuxième appareil de mesure de puissance (2) est conçu, pour la synchronisation du deuxième appareil de mesure de puissance (2) et du premier appareil de mesure de puissance (1),
- pour envoyer un message de synchronisation au premier appareil de mesure de puissance (1),
- pour déterminer une durée jusqu'à l'arrivée d'une réponse du premier appareil de mesure de puissance (1), et
- pour estimer la moitié de la durée jusqu'à l'arrivée de la réponse du premier appareil de mesure de puissance (1) en tant que temps de transmission du message de synchronisation, et
**en ce que** le dispositif de mesure du deuxième appareil de mesure de puissance (2) est conçu pour prendre en compte, dans le cas d'un traitement des résultats de la mesure du premier appareil de mesure de puissance (1), le temps de transmission estimé du message de synchronisation en tant que retard d'une transmission d'instructions de commande et des résultats de la mesure.

10. Système de mesure selon l'une quelconque des revendications 1 à 9,
**caractérisé**
**en ce que** le dispositif de communication (13) du premier appareil de mesure de puissance (1) est conçu pour communiquer avec au moins deux, en particulier deux, ou trois, ou quatre, ou cinq, ou six, ou sept, ou huit, ou neuf, ou dix autres appareils de mesure de puissance (1, 2, 3),
**en ce que** le premier appareil de mesure de puissance (1) est conçu pour mesurer conjointement avec les autres appareils de mesure de puissance (1, 2, 3) une puissance sur d'autres phases (L1, L2, L3) du système polyphasé, en particulier du système triphasé,
**en ce que** le dispositif de communication du deuxième appareil de mesure de puissance (2) est conçu pour communiquer avec au moins deux, en particulier deux, ou trois, ou quatre, ou cinq, ou six, ou sept, ou huit, ou neuf, ou dix autres appareils de mesure de puissance (1, 2, 3), et
**en ce que** le deuxième appareil de mesure de puissance (2) est conçu pour mesurer conjointement avec les autres appareils de mesure de puissance (1, 2, 3) une puissance sur d'autres phases (L1, L2, L3) du système polyphasé, en particulier du système triphasé.

11. Système de mesure selon l'une quelconque des revendications 2 ou 3,
**caractérisé**
**en ce que** le premier appareil de mesure de puissance (1) est conçu pour travailler dans le mode maître, et
**en ce que** le au moins un deuxième appareil de mesure de puissance (2, 3) est conçu pour fonctionner en mode esclave.

12. Système de mesure selon la revendication 11,
**caractérisé**
**en ce que** le système de mesure (29, 39, 49) dispose d'au moins deux, en particulier de deux, ou de trois, ou de quatre, ou de cinq, ou de six, ou de sept, ou de huit, ou de neuf, ou de dix deuxièmes appareils de mesure de puissance (2, 3),
**en ce que** chaque deuxième appareil de mesure de puissance (2, 3) est conçu pour mesurer une puissance sur une phase (L2, L3) différente du système polyphasé, en particulier du système triphasé, et
**en ce que** le premier appareil de mesure de puissance (1) et les deuxièmes appareils de mesure de puissance (2, 3) sont conçus pour mesurer conjointement la puissance sur une pluralité de phases (L1, L2, L3), de préférence sur toutes les phases (L1, L2, L3) du système polyphasé.

13. Système de mesure selon la revendication 9,
**caractérisé**
**en ce que** le premier appareil de mesure de puissance (1) est conçu pour envoyer le message de synchronisation au au moins un deuxième appareil de mesure de puissance (2, 3), et
**en ce que** le au moins un deuxième appareil de mesure de puissance (2, 3) est conçu pour envoyer une réponse au message de synchronisation au premier appareil de mesure de puissance (1), dès qu'il a reçu le message de synchronisation.

14. Système de mesure selon l'une quelconque des revendications 10 à 13,
**caractérisé**
**en ce que** le système de mesure (29, 39, 49) dispose de lignes de mesure de longueur identique pour le raccordement du premier appareil de mesure de puissance (1) et du au moins un deuxième appareil de mesure de puissance (2, 3) aux phases (L1, L2, L3) du système polyphasé, en particulier du système triphasé.

15. Système de mesure selon la revendication 7,
**caractérisé**
**en ce que** le système de mesure (29, 39, 49) dispose d'un dispositif de raccordement pour la liaison automatique des appareils de mesure de puissance (1, 2, 3) lorsque l'appareil de mesure de puissance (1, 2, 3) respectif et le dispositif de raccordement sont branchés l'un à l'autre.
